(19) Europäisches Patentamt
European Patent Office
Office européen des brevets

(11) **EP 2 839 727 B1**

(12) **EUROPÄISCHE PATENTSCHRIFT**

(45) Veröffentlichungstag und Bekanntmachung des Hinweises auf die Patenterteilung:
**10.07.2019 Patentblatt 2019/28**

(21) Anmeldenummer: **13720848.4**

(22) Anmeldetag: **24.04.2013**

(51) Int Cl.:
*H05K 13/08* (2006.01)    *G06Q 10/00* (2012.01)

(86) Internationale Anmeldenummer:
**PCT/EP2013/058526**

(87) Internationale Veröffentlichungsnummer:
**WO 2014/005743 (09.01.2014 Gazette 2014/02)**

(54) **ZUORDNUNG VON LEITERPLATTEN AUF BESTÜCKUNGSLINIEN**

ALLOCATION OF PRINTED CIRCUIT BOARDS TO FITTING LINES

AFFECTATION DE CARTES DE CIRCUITS IMPRIMES SUR DES LIGNES DE MONTAGE

(84) Benannte Vertragsstaaten:
**AL AT BE BG CH CY CZ DE DK EE ES FI FR GB GR HR HU IE IS IT LI LT LU LV MC MK MT NL NO PL PT RO RS SE SI SK SM TR**

(30) Priorität: **06.07.2012 DE 102012211812**

(43) Veröffentlichungstag der Anmeldung:
**25.02.2015 Patentblatt 2015/09**

(73) Patentinhaber: **Siemens Aktiengesellschaft 80333 München (DE)**

(72) Erfinder:
• **PFAFFINGER, Alexander 81739 München (DE)**
• **ROYER, Christian 85521 Ottobrunn (DE)**
• **HEROLD, Norbert 96123 Litzendorf (DE)**
• **KEMPER, Thorsten 91220 Schnaittach (DE)**
• **CRAIOVAN, Daniel 90491 Nürnberg (DE)**

(56) Entgegenhaltungen:
**EP-A1- 0 478 360    EP-A1- 0 478 361**

• **HANS -OTTO GÜNTHER ET AL: "Workload planning in small lot printed circuit board assembly", OR SPECTRUM, Bd. 19, Nr. 2, 1. Juni 1997 (1997-06-01), Seiten 147-157, XP055085604, ISSN: 0171-6468, DOI: 10.1007/BF01545517**

EP 2 839 727 B1

**Beschreibung**

Die vorliegende Erfindung betrifft ein Verfahren zur Zuordnung von Leiterplatten auf Bestückungslinien zur Bestückung der Leiterplatten oder anderer Baugruppen mit Bauelementen. Weiterhin betrifft die Erfindung eine Steuereinrichtung für eine Fertigungs- oder Montagelinie zur Bestückung von Leiterplatten mit Bauelementen. Außerdem betrifft die Erfindung ein Computerprogrammprodukt und ein computerlesbares Medium.

Insbesondere im Bereich der Elektronikproduktion werden zu fertigende Leiterplatten bzw. Baugruppen auf SMT-Bestückungslinien durch Oberflächenmontage (surface mounted technology, SMT) hergestellt. Auf Grund von technischen Restriktionen kann aber nicht jede Leiterplatte auf jeder Bestücklinie gefertigt werden. Die Leiterplatten besitzen auf den Bestückungslinien meist auch unterschiedliche Produktionszeiten. Zudem dürfen die maximalen Produktionszeitkapazitäten der Bestückungslinien nicht überschritten werden.

DE 10 2009 013 353 B3 zeigt ein Verfahren zur Rüstung einer solchen Bestückungslinie.

EP 0 478 360 A1 betrifft ein weiteres Bestückungsverfahren, bei dem versucht wird, eine Einrichtungszeit für eine Produktionslinie zur Bestückung von Leiterplatten zu verbessern.

Hans-Otto Günther et al. "Workload planning in small lot printed circuit board assembly", OR Spectrum, Bd. 19, Nr. 2, 1. Juni 1997, S. 147-157 betrifft die Planung einer Arbeitsauslastung bei der automatisierten Bestückung von Leiterplatten.

EP 0 478 361 A1 betrifft ein Verfahren zur Bestückung von Leiterplatten mit Bauelementen, wobei eine Produktionshäufigkeit eines Leiterplattentyps und die zur Produktion erforderlichen Bauelemente berücksichtigt werden.

Die Zuordnung von Leiterplatten auf Bestücklinien eines Bestückungssystems erfolgt üblicherweise manuell oder halbautomatisch, basierend auf Erfahrungswerten oder Heuristiken. Dabei hat es sich in der Praxis gezeigt, dass immer wieder unausgewogene Zuordnungen getroffen werden, die eine hohe Auslastung einer Komponente einer Bestückungslinie mit einer niedrigen Auslastung einer anderen Komponente bedingen, so dass das Bestückungssystem nicht optimal genutzt werden kann.

Es ist Aufgabe der vorliegenden Erfindung, eine verbesserte Technik zur Zuordnung von Leiterplatten auf Bestückungslinien bereitzustellen.

Die Erfindung löst diese Aufgabe mittels eines Verfahrens, eines Computerprogrammprodukts und einer Steuereinrichtung mit den Merkmalen der unabhängigen Ansprüche. Unteransprüche geben bevorzugte Ausführungsformen wieder.

Ein Bestückungssystem umfasst mehrere Bestückungslinien zur Bestückung von Leiterplatten mit elektronischen Bauteilen. Ein Verfahren zur Zuordnung von Leiterplatten an die Bestückungslinien umfasst Schritte des Erfassens von Anforderungen zur Bestückung mehrerer Leiterplatten mit jeweils zu bestückenden Bauteilen, des Bestimmens einer Menge von Leiterplatten, deren Bauteilevarianzen ein vorbestimmtes Maß übersteigen, wobei eine Bauteilevarianz jeweils die Anzahl unterschiedlicher, auf einer Leiterplatte zu bestückender Bauteile repräsentiert, und des Zuordnens der Leiterplatten an die Bestückungslinien unter den gegebenen Vorgaben mittels ganzzahliger oder gemischt ganzzahliger Linearer Programmierung derart, dass die Leiterplatten der Menge möglichst gleichmäßig über die Bestückungslinien verteilt sind. Anders ausgedrückt ist einer der Parameter der ganzzahligen Linearen Programmierung so gewählt, dass bei der Zuordnung eine Optimierung bezüglich der Gleichverteilung der Leiterplatten der Menge über die Bestückungslinien erfolgt.

Komplexe Leiterplatten können identifiziert und in der Menge gesammelt werden, so dass eine Zuordnung übermäßig vieler komplexer Leiterplatten an eine Bestückungslinie vermieden werden kann. So kann insbesondere vermieden werden, dass eine Bestückungslinie häufig umgerüstet werden muss, weil die an der Bestückungslinie vorgehaltenen Bauteile nicht für alle der Bestückungslinie zugeordneten Leiterplatten ausreichend sind. Verfügt die Bestückungslinie über einen Bestückungsautomaten mit mehreren sogenannten Zuführtischen, so kann während der Produktion eine vergrößerte Anzahl fester Tische gebildet werden, die für eine Zuordnung einer Leiterplatte an die Bestückungslinie nicht gewechselt werden müssen. Eine Anzahl vorzuhaltender Wechseltische und der damit verbundene Rüst- und Wartungsaufwand können gesenkt werden. Damit können Kosten in substantiellen Größenordnungen eingespart werden. Das Verfahren lässt sich prinzipiell auf alle Arten von Bestückungssystemen anwenden.

In einer bevorzugten Ausführungsform wird einer Bestückungslinie nicht mehr als eine vorbestimmte Anzahl Leiterplatten aus der Menge zugeordnet. Diese vorbestimmte Anzahl kann beispielsweise bei 1 oder 2 liegen. Durch die Beschränkung kann die Bestückungslinie vor häufigen Eingriffen zum Wechseln von vorgehaltenen Bauteilen aufgrund überhöhter Bauteilevarianzen geschützt werden. In einer Ausführungsform wird die vorbestimmte Anzahl individuell für jede Bestückungslinie auf der Basis von Kennzahlen oder Fertigkeiten jeder Bestückungslinie bestimmt.

In einer weiter bevorzugten Ausführungsform, die mit der letztgenannten Ausführungsform kombinierbar ist, kann einer Bestückungslinie wenigstens eine vorbestimmte Anzahl Leiterplatten aus der Menge zugeordnet werden. Dadurch können die bestehenden Kapazitäten der Bestückungslinie sinnvoll ausgenutzt werden. Dies kann dazu beitragen, dass die Leiterplatten der Menge zeitnah bearbeitet werden können. Auch hier kann eine individuelle Bestimmung der vorbestimmten Anzahl erfolgen.

In einer besonders bevorzugten Ausführungsform wird eine Zuordnung einer Leiterplatte an eine Bestückungslinie verhindert, falls die Bauteilevarianz der symmetrischen Differenz der auf den beiden Leiterplatten zu bestückenden Bauteile eine vorbestimmte Schranke übersteigt. Durch dieses Maß können gemeinsam benutzbare Bauteile beider Leiterplatten berücksichtigt werden, so dass eine verbesserte Bestimmung von Leiterplatten, die sich gegenseitig auf einer Bestückungslinie behindern, möglich ist. Ungünstige Kombinationen von Leiterplatten, die derselben Bestückungslinie zugeordnet sind und zu einem stark gesteigerten Rüstaufwand führen können, können so vermieden werden.

In einer weiteren Ausführungsform wird die Zuordnung nur verhindert, falls auch die Bauteilevarianzen beider Leiterplatten jeweils eine vorbestimmte Schranke übersteigen. So können nur komplexe Leiterplatten zwangsweise unterschiedlichen Bestückungslinien zugeordnet werden. Leiterplatten mit geringen Bauteilevarianzen behindern sich gegenseitig erfahrungsgemäß wenig, so dass ein gegenseitiger Ausschluss solcher Leiterplatten nicht erforderlich sein kann.

Ferner kann die Zuordnung nur dann verhindert werden, falls auch die Bauteilevarianz der Vereinigungsmenge der auf den beiden Leiterplatten zu bestückenden Bauteile eine vorbestimmte Schranke übersteigt. Dadurch kann berücksichtigt werden, dass der positive Aspekt gemeinsam benutzbarer Bauteile den negativen Effekt disjunkter Bauteile ganz oder teilweise aufwiegen kann. Die Bestimmung der relativen Verschiedenheit der Leiterplatten kann dadurch weiter verbessert werden.

In einer besonders bevorzugten Ausführungsform umfasst das ganzzahlige lineare Programm Schritte des Ermittelns einer Startzuordnung von Leiterplatten auf Bestückungslinien als aktuelle Zuordnung und des Zuordnens einer ausgewählten Menge von Leiterplatten auf die Bestückungslinien, basierend auf der aktuellen Zuordnung, mittels ganzzahliger oder gemischt ganzzahliger linearer Programmierung. Auch ein großes oder komplexes Zuordnungsproblem, das durch eine große Anzahl unterschiedlicher Leiterplatten, viele unterschiedliche, auf den Leiterplatten zu bestückende Bauteile oder Fertigungslinien mit unterschiedlichen Eigenschaften bedingt sein kann, kann so in akzeptabler Zeit mit ausreichender Güte getroffen werden. Die Zuordnung der Leiterplatten auf die Bestückungslinien für die Startzuordnung kann zufällig oder gezielt erfolgen. Dabei können beispielsweise die Bestückungslinien ausgewählt werden, die optimiert werden sollen, während die anderen Bestückungslinien konstant gelassen werden. Die Startzuordnung kann auch durch eine heuristische Zuordnung erfolgen.

In einer Ausgestaltung kann dieses Verfahren iterativ durchgeführt werden, bis die bestimmte Zuordnung eine vorbestimmte Qualität erreicht hat oder eine vorbestimmte Verarbeitungszeit abgelaufen ist. Dadurch kann eine sukzessive Annäherung an eine optimale Lösung erfolgen.

Ein Computerprogrammprodukt umfasst Programmcodemittel zur Durchführung des beschriebenen Verfahrens, wenn es auf einer Ausführungseinrichtung abläuft oder auf einem computerlesbaren Medium gespeichert ist. Das Computerprogrammprodukt kann in einer üblichen Programmiersprache (z.B. C++, Java) erstellt sein. Die Verarbeitungseinrichtung kann einen marktüblichen Computer oder Server mit entsprechenden Eingabe-, Ausgabe- und Speichermitteln umfassen.

Eine Steuereinrichtung zur Zuordnung von Leiterplatten an Bestückungslinien eines Bestückungssystems ist dazu eingerichtet, das oben angegebene Verfahren durchzuführen.

Die oben beschriebenen Eigenschaften, Merkmale und Vorteile dieser Erfindung sowie die Art und Weise, wie diese erreicht werden, werden klarer und deutlicher verständlich im Zusammenhang mit der folgenden Beschreibung der Ausführungsbeispiele, die im Zusammenhang mit den Zeichnungen näher erläutert werden, wobei:

Fig. 1    ein Bestückungssystem;

Fig. 2    eine Veranschaulichung von Bauteilevarianzen von Leiterplatten aus Fig. 1;

Fig. 3    ein Ablaufdiagramm eines ersten Verfahrens; und

Fig. 4    ein Ablaufdiagramm eines zweiten Verfahrens als Teil des Verfahrens von Fig. 3

darstellt.

Die Lineare Optimierung ist eines der Hauptverfahren auf dem Gebiet mathematische Optimierung und befasst sich mit der Optimierung linearer Zielfunktionen über einer Menge, die durch lineare Gleichungen und Ungleichungen eingeschränkt ist. Die Lineare Optimierung ist die Grundlage der Lösungsverfahren der (gemischt) ganzzahligen Linearen Optimierung.

Vorteile der Linearen Optimierung:

- Globaler Optimierungsansatz.
- Leicht erweiterbar.
- Sehr gute kommerzielle Standard-Solver (SCIP, CPLEX, Ilog, Xpress), die in der Praxis weit verbreitet und bewährt sind.

- Für eine ermittelte Lösung ist bekannt, wie weit sie maximal von der optimalen Lösung entfernt ist (Gap).

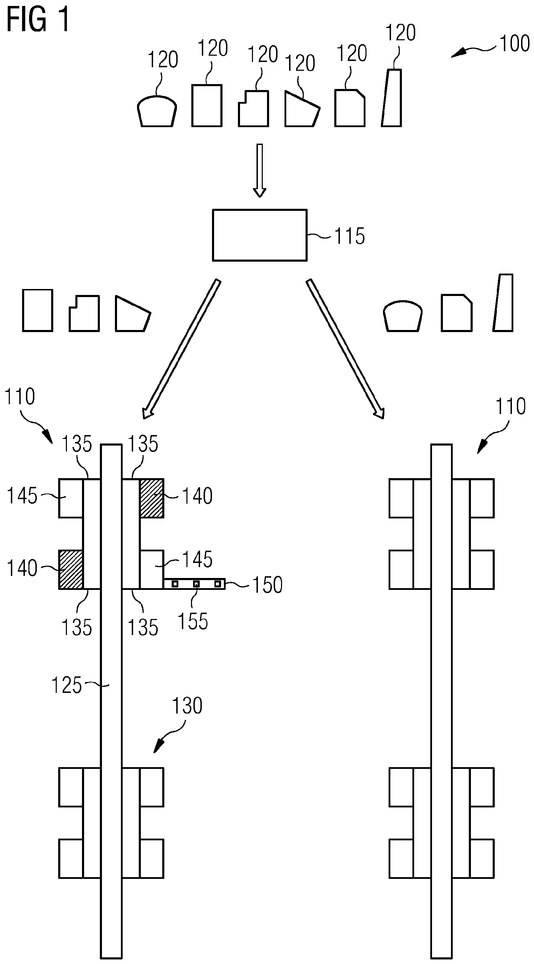

Figur 1 zeigt ein Bestückungssystem 100. Das Bestückungssystem 100 umfasst mehrere Bestückungslinien 110 und eine Steuereinrichtung 115 zur Zuordnung von Leiterplatten 120 an die Bestückungslinien 110. Jede Bestückungslinie 110 umfasst üblicherweise ein Transportsystem 125 und ein oder mehrere Bestückungsautomaten 130. Jeder Bestückungsautomat 130 umfasst einen oder mehrere Bestückungsköpfe 135, die jeweils dazu eingerichtet sind, von einem konstanten Tisch 140 oder einem variablen Tisch 145 Bauelemente aufzunehmen und an einer vorbestimmten Position auf der Leiterplatte 120 zu positionieren, die sich auf dem Transportsystem 125 befindet.

Während des Bestückungsvorgangs besteht die Leiterplatte 120 bezüglich des Bestückungsautomaten 130 üblicherweise still. Die Tische 140, 145 umfassen jeweils eine Vielzahl Zuführungseinrichtungen 150, von denen nur eine exemplarisch dargestellt ist. Jede Zuführungseinrichtung 150 hält einen Vorrat von Bauteilen 155 eines vorbestimmten Typs bereit. Zwar kann jede Zuführungseinrichtung 150 zur Bereithaltung unterschiedlicher Bauteile 155 konfiguriert werden und unterschiedliche Zuführungseinrichtungen 150 an einem Tisch 140, 145 angebracht werden, jedoch werden die Tische 140, 145 aus Geschwindigkeitsgründen üblicherweise komplett ausgetauscht, wenn ein Bestückungsautomat 130 mit Bauteilen 155 versorgt werden muss, die nicht auf einem der angebrachten Tische 140, 145 vorgehalten sind.

Da ein solcher Wechsel üblicherweise mit einem Produktionsstillstand verbunden ist, wird angestrebt, die Zahl der zu wechselnden Tische 140, 145 gering zu halten. Wird ein Tisch während eines Umrüstvorgangs nicht ausgetauscht, so wird er als konstanter Tisch 140 bezeichnet, ansonsten als variabler Tisch 145. Funktionale Unterschiede zwischen einem konstanten Tisch 140 und einem variablen Tisch 145 bestehen ansonsten nicht.

Die Leiterplatte 120 ist mit einer Anzahl unterschiedlicher Bauteile 155 zu bestücken. Um ein häufiges Wechseln von variablen Tischen 145 zu minimieren und idealerweise eine Zahl konstanter Tische 140 zu maximieren, ist die Steuereinrichtung 115 dazu eingerichtet, die Zuordnung einer Leiterplatte 120 an eine der Bestückungslinien 110 zu optimieren. Dabei müssen üblicherweise spezifische Eigenschaften jeder Bestückungslinie 110 bzw. jedes Bestückungsautomaten 130 genauso berücksichtigt werden, wie Eigenschaften der Leiterplatten 120 bzw. der auf ihnen zu bestückenden Bauteile 155.

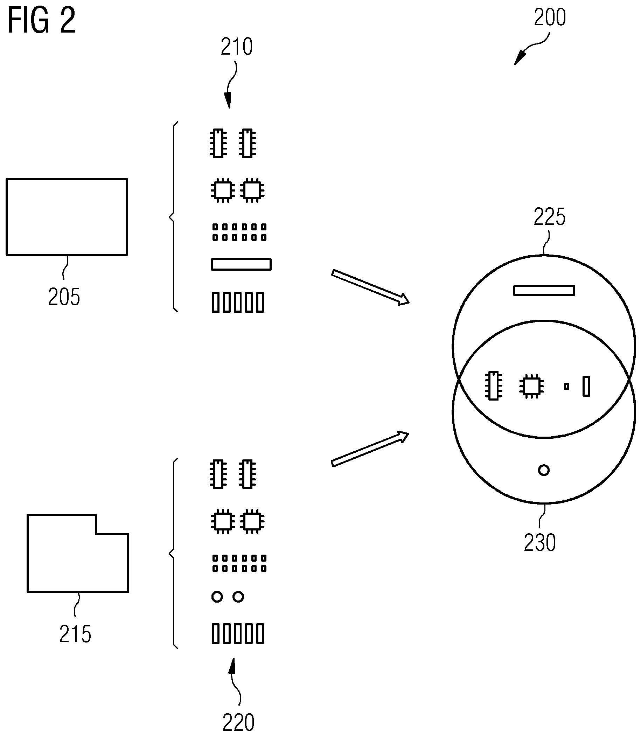

Figur 2 zeigt eine Veranschaulichung von Bauteilevarianzen von Leiterplatten 120 aus Figur 1. Eine Menge 200 von komplexen Leiterplatten 120 umfasst eine erste Leiterplatte 205, die mit einer ersten Menge 210 von Bauteilen 155 zu bestücken ist, und eine zweite Leiterplatte 215, die mit einer zweiten Menge 220 von Bauteilen 155 aus Figur 1 zu bestücken ist. Beide Leiterplatten 205, 215 entsprechen einer der Leiterplatten 120 aus Figur 1.

Die erste Menge 210 umfasst Bauteile 155 von fünf unterschiedlichen Bauteiltypen, die in der Bestückungslinie 130 in wenigstens fünf unterschiedlichen Zuführungseinrichtungen 150 bereit gehalten werden können. Analog dazu umfasst die zweite Menge 220 ebenfalls Bauelemente 150 fünf unterschiedlicher Bauteiltypen, die in wenigstens fünf unterschiedlichen Zuführungseinrichtungen 150 bereit gehalten werden können. Horizontal nebeneinander dargestellte Bauelemente 155 sind zueinander gleich und werden üblicherweise in derselben Zuführungseinrichtung 150 vorgehalten, wobei im Rahmen des Zuordnungsproblems üblicherweise von einem unendlichen Vorrat vorhandener Bauteile 155 eines Bauteiltyps ausgegangen wird.

Die Anzahl der unterschiedlichen Bauteile 155, die auf einer Leiterplatte 205, 215 zu bestücken ist, wird Bauteilevarianz der Leiterplatte 205 bzw. 215 genannt. Die Bauteilevarianz beider Leiterplatten 205, 215 zusammen ist somit die Anzahl unterschiedlicher Bauteile 155, die auf beiden Leiterplatten 205, 215 zu bestücken sind.

Unterschiedliche Bauteile 155 werden im Folgenden auch Bauteiltypen genannt. Auf der ersten Leiterplatte 205 ist also eine erste Menge 225 von Bauteiltypen und auf der zweiten Leiterplatte 215 eine zweite Menge 230 von Bauteiltypen zu bestücken, wobei die Anzahl der in den Mengen 225, 230 enthaltenen Bauteiltypen jeweils der Bauteilvarianz entspricht. Die Bauteilevarianz beider Leiterplatten 205 und 215 zusammen entspricht somit der Anzahl Bauteiltypen in der Vereinigungsmenge der Mengen 225 und 230. Obwohl also jede der Leiterplatten 205, 215 jeweils eine Bauteilevarianz von 5 aufweist, liegt die Bauteilevarianz beider Leiterplatten 205, 215 zusammen bei 6, da auf jeder Leiterplatte 120 ein Bauteil 155 eines Bauteiltyps zu bestücken ist, der an der jeweils anderen Leiterplatte 120 nicht verwendet wird.

Um eine möglichst vorteilhafte Zuordnung von Leiterplatten 120 an die Bestückungslinien 110 zu erreichen, wird angestrebt, Leiterplatten 205, 215 mit einer besonders hohen Bauteilevarianz möglichst gleichmäßig den Bestückungslinien 110 zuzuordnen. In einer Ausführungsform wird dazu versucht, paarweise Unterschiede zwischen den Anzahlen einer Bestückungslinie 110 zugeordneter Leiterplatten 120 hoher Bauteilvarianz möglichst zu minimieren. In einer anderen Ausführungsform sind eine untere und eine obere Schranke für die jeweiligen Anzahlen komplexer Leiterplatten 120 auf den Bestückungslinien 110 vorgegeben. Eine untere Schranke kann beispielsweise 1 oder 2 sein, während eine obere Schranke beispielsweise zwischen 2 und 4 liegen kann. Eine ausreichend gleichmäßige Zuordnung komplexer Leiterplatten 120 an Bestückungslinien 110 kann dann akzeptiert werden, wenn die Anzahlen die vorbestimmten Schranken nicht übersteigen bzw. unterschreiten.

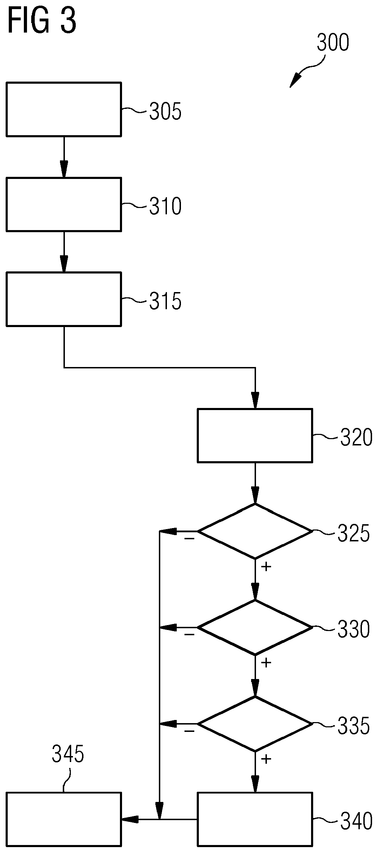

Figur 3 zeigt ein Ablaufdiagramm eines ersten Verfahrens 300 zur Durchführung dieser Zuordnung.

Schritt 305: Zunächst werden Anforderungen zur Zuordnung von Leiterplatten 120 erfasst. Eine Anforderung definiert eine Leiterplatte 120 und die auf ihr zu bestückenden Bauteile 155. Zusätzlich kann eine Anzahl von Randbedingungen angegeben sein, beispielsweise welche Leiterplatte 110 auf welcher Bestückungslinie 110 bestückt werden kann oder welches Bauelement 155 durch die Bestückungslinie 110 verarbeitbar ist. Weitere Randbedingungen finden sich unten bei der Diskussion des mathematischen Hintergrunds.

Schritt 310: Anschließend wird für jede der Leiterplatten 120 eine Bauteilevarianz bestimmt, wie oben mit Bezug auf Figur 2 ausgeführt ist.

Schritt 315: Danach wird eine Menge 200 von Leiterplatten 120 bestimmt, deren Bauteilevarianzen besonders hoch sind. Es können insbesondere diejenigen Leiterplatten in die Menge 200 einsortiert werden, deren Bauteilevarianzen über einer vorbestimmten Schwelle liegen. Alternativ dazu können die Leiterplatten 120 auch nach ihren Bauteilevarianzen sortiert und eine vorbestimmte Anzahl der Leiterplatten 120 mit den höchsten Bauteilevarianzen in die Menge 200 übernommen werden.

Mischformen und andere Vorgehensweisen sind ebenfalls möglich.

In einer Ausführungsform kann danach unmittelbar eine Zuordnung von Leiterplatten 120 an Bestückungslinien 110 in einem Schritt 345 durchgeführt werden. Bevorzugterweise wird zuvor jedoch noch bestimmt, welche Leiterplatten 205, 215 der im Schritt 315 bestimmten Menge 200 stark unterschiedliche Mengen 225, 230 von Bauteiltypen erfordern, um solche Leiterplatten 205, 215 möglichst unterschiedlichen Bestückungslinien 110 zuzuordnen. In einer weiteren Ausführungsform erfolgt diese Bestimmung bereits zu einem früheren Zeitpunkt, so dass die Menge 200 im Schritt 315 derart gebildet wird, dass nur stark unterschiedliche komplexe Leiterplatten 120 in die Menge 200 aufgenommen werden.

Schritt 320: Zur Bestimmung ihrer Unterschiedlichkeit werden zunächst zwei Leiterplatten 120 aus der Menge 200 komplexer Leiterplatten 120 ausgewählt. Bevorzugterweise erfolgt das Auswählen in mehreren iterativen Durchläufen so, dass schließlich alle Paare von Leiterplatten 120 der Menge 200 bezüglich der Unterschiedlichkeit der auf ihnen zu bestückenden Bauteiltypen überprüft werden können. Bezogen auf das Beispiel von Fig. 2 werden etwa die Leiterplatten 205 und 210 ausgewählt.

Schritt 325: Dann wird bestimmt, ob die Anzahl von Bauteiltypen in jeder Menge 225, 230 von Bauteiltypen, die auf den ausgewählten Leiterplatten 205 und 215 zu bestücken sind, eine vorbestimmte erste Schranke übersteigt. Im Beispiel von Fig. 2 sind auf beiden Leiterplatten 205 und 230 jeweils fünf Bauteiltypen zu bestücken; die korrespondierenden Mengen 225 und 230 enthalten jeweils 5 Bauteiltypen.

Schritt 330: Wird die erste Schranke wie beschrieben überschritten, so fährt das Verfahren mit Schritt 330 fort, in dem überprüft wird, ob die Anzahl der Bauteiltypen der symmetrischen Differenz der Mengen 225 und 230 eine vorbestimmte zweite Schranke übersteigt. Die symmetrische Differenz der Mengen 225 und 230 umfasst die Vereinigungsmenge der Mengen 225 und 230 abzüglich der Schnittmenge der Mengen 225 und 230. Anders ausgedrückt umfasst die symmetrische Differenz diejenigen Bauteiltypen, die zwischen den Leiterplatten 205 und 215 disjunkt sind, also exklusiv nur in der ersten Menge 225 oder nur in der zweiten Menge 230 vorhanden sind. Im Beispiel von Fig. 2 umfasst die symmetrische Differenz zwei Bauteiltypen.

Schritt 335: Übersteigt die Anzahl der disjunkten Bauteile 155 die zweite Schranke, so wird in Schritt 335 bestimmt, ob die Vereinigungsmenge der Mengen 225 und 230 mehr Bauteiltypen umfasst, als durch eine dritte vorbestimmte Schranke vorgegeben ist. Im Beispiel von Fig. 2 umfasst die Vereinigungsmenge 6 Bauteiltypen. Verläuft auch dieser Test positiv, so wird in einem Schritt 340 die Paarung der ausgewählten Leiterplatten 205 und 215 auf der gleichen Bestückungslinie 110 verhindert.

Verläuft der Test einer der Schritte 325 bis 335 hingegen negativ, so wird die Paarung der Leiterplatten 205 und 215 nicht explizit verhindert. Ob die ausgewählten Leiterplatten 205 und 215 im Schritt 245 dann auch der gleichen Bestückungslinie 110 zugeordnet werden, ist dadurch aber noch nicht sicher gestellt. In anderen Ausführungsformen des Verfahrens 300 können auch einer oder mehrere der Schritte 325 bis 335 entfallen; außerdem kann auch eine andere Reihenfolge der Schritte 325 bis 335 angewendet werden.

Schritt 345: Schließlich werden dann die Leiterplatten 120 den Bestückungslinien 110 derart zugeordnet, dass die Leiterplatten 120 der im Schritt 315 bestimmten Menge 200 möglichst gleichmäßig über die unterschiedlichen Bestückungslinien 110 verteilt sind. Neben der möglichen Randbedingung der zu vermeidenden Paarung der stark unterschiedlichen Leiterplatten 205, 215 kann die Zuordnung noch weitere Randbedingungen berücksichtigen, insbesondere Eigenheiten eines Bestückungsautomaten 130 einer Bestückungslinie 110, wie etwa die Möglichkeit zur Handhabung besonders großer oder besonders kleiner Bauteile 155.

Das Zuordnen im Schritt 345 unter den gegebenen Vorgaben erfolgt bevorzugterweise mittels ganzzahliger linearer Programmierung.

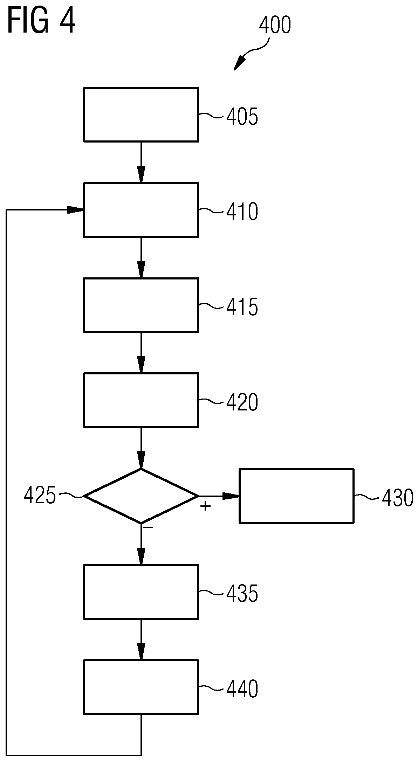

Ein einbettendes Verfahren 400 ist in Form eines Ablaufdiagramms in Figur 4 dargestellt.

Schritt 405: Zunächst wird eine Startzuordnung von Leiterplatten 120 auf Bestückungslinien 110 bestimmt und eine aktuelle Zuordnung wird der Startzuordnung gleichgesetzt. Für die Ermittlung der Startzuordnung sind unterschiedliche Heuristiken möglich, die auch manuelle Vorgaben oder Restriktionen umfassen können.

Schritt 410: Anschließend wird eine Teilmenge von Leiterplatten 120 aus den zuzuordnenden Leiterplatten 120 ausgewählt.

Schritt 415: Danach werden dann eine oder mehrere alternative Zuordnungen von Leiterplatten 120 der Teilmenge an die Bestückungslinien 110 gebildet, vorzugsweise mittels ganzzahliger linearer Programmierung. Diese Zuordnung erfolgt auf die mit Bezug auf Figur 3 beschriebene Weise derart, dass die unterschiedlichen komplexen Leiterplatten 120 möglichst gleichmäßig den Bestückungslinien 110 zugeordnet werden. Gleichzeitig soll die Bauelementevarianz aller Bestückungslinien 110 möglichst minimiert sein.

Schritt 420: Hier werden die Qualitäten der in Schritt 415 gebildeten Zuordnungen bestimmt bzw. aus den Parametern der linearen Optimierung von Schritt 415 übernommen. Dabei sind üblicherweise einer oder mehrere Qualitätsparameter vorgegeben, die beispielsweise einen Auslastungsgrad eines Bestückungsautomaten 130 oder das Verhältnis von konstanten Tischen 140 zu variablen Tischen 145 umfassen können. Im Zusammenhang mit dem Verfahren von Figur 3 wird vorzugsweise als einziger Qualitätsparameter die Bauelementevarianz aller Bestückungslinien 110 möglichst minimiert.

Schritt 425: Danach wird überprüft, ob ein vorbestimmtes Abbruchkriterium erreicht ist. Das Abbruchkriterium kann eine Zuordnung einer vorbestimmten Qualität oder das Ablaufen einer vorbestimmten Rechenzeit für das Verfahren 400 umfassen.

Schritt 430: Die bestimmten Zuordnungen werden ausgegeben, falls das Abbruchkriterium erfüllt ist.

Schritt 435: Andernfalls können unter den bestimmten Zuordnungen solche ausgewählt werden, die weiter optimiert werden sollen.

Schritt 440: In diesem Fall wird die aktuelle Zuordnung auf eine der zu optimierenden Zuordnungen gesetzt und das Verfahren 400 kann ab dem Schritt 410 erneut durchlaufen. Wurden mehrere optimierbare Zuordnungen ausgewählt, so kann das Verfahren 400 auch entsprechend mehrfach parallel verzweigt werden.

Mathematischer Hintergrund

Durch den Einsatz von exakten mathematischen Verfahren lassen sich deutlich bessere Lösungen erzielen als mit bisher in der Praxis verwendeten Heuristiken. Im weiteren Unterschied dazu können mit diesen Verfahren auch gute Produktionszeiten erreicht werden.

Bei der Zuordnung von Leiterplatten 120 bzw. Baugruppen an eine Bestückungslinie 110 ist zu beachten, dass auf Grund von technischen Restriktionen möglicherweise nicht jede Leiterplatte 120 auf jeder Bestückungslinie 110 gefertigt werden kann. Die Leiterplatten besitzen auf den Bestückungslinien 110 meist auch unterschiedliche Produktionszeiten. Zudem dürfen die maximalen Produktionszeitkapazitäten der Bestückungslinien 110 nicht überschritten werden.

Bei der Zuordnung von Leiterplatten 120 auf Bestückungslinien 110 werden üblicherweise folgende Ziele verfolgt:

- es sollen möglichst viele Leiterplatten 120 mit konstanten Tischen 140 gefertigt werden können, um den Umrüstaufwand zu reduzieren
- die Anzahl der Rüstfamilien an den Bestückungslinien 110 soll möglichst gering sein, um den zeitlichen Umrüstaufwand zu reduzieren
- man möchte möglichst wenig Rüstequipment (z.B. Förderer 150) benötigen
- die Gesamtproduktionszeit für die Leiterplatten 120 sollte möglichst minimal sein.

Dabei ist eine Rüstfamilie bestimmt als eine Menge von Leiterplatten, die auf einer Bestückungslinie bestückt werden können, ohne die Menge der Bauteiltypen zu ändern, die an der Bestückungslinie für die Bestückung bereit gehalten sind. Die Menge der an der Bestückungslinie bereit gehaltenen Bauteiltypen wird auch Rüstung genannt. Es wird üblicherweise davon ausgegangen, dass stets ausreichend viele Bauteile jedes Bauteiltyps an der Bestückungslinie bereit gehalten sind.

Üblicherweise sind einer Bestückungslinie mehr Leiterplatten zugeordnet als von einer Rüstfamilie umfasst sein können, da an der Bestückungslinie nicht beliebig viele Bauteiltypen bereit gehalten werden können. Die Bestückungslinie wird daher gelegentlich einem Rüstwechsel unterzogen, bei dem die Rüstung für eine erste Rüstfamilie gegen die Rüstung für eine zweite Rüstfamilie gewechselt wird. Je seltener diese Rüstwechsel sind und je weniger Bauteiltypen bei einem Rüstwechsel gewechselt werden müssen, desto kostengünstiger kann das Bestückungssystem betrieben werden.

Diese Ziele versucht man gewöhnlich zu erreichen, indem eine möglichst hohe Bauteilüberdeckung der Leiterplatten 120 einer Bestückungslinie 110 angestrebt wird, bzw. die Summe der Bauelementvarianzen der Bestückungslinien 110 minimiert wird.

Zur Bestimmung einer optimierten Zuordnung von Leiterplatten 120 an Bestückungslinien 110 werden IP-Modelle (IP steht für Integer Programmierung bzw. für Integer Programm oder ganzzahliges Optimierungsmodell) verwendet. Diese Bestimmung kann mittels eines bekannten Standard-Solvers durchgeführt werden.

**Indices**

L      Menge der SMT-Bestücklinien 110 des Systems 100
R      Menge der Leiterplatten 120
C      Menge der Bauelementtypen 155

$R_c$      Menge der Leiterplatten mit Bauelementtyp c
$R_l$      Menge der bestückbaren Leiterplatten auf Linie $l$

**Parameter**

$Time_{r,l}$      Gesamtproduktionszeit für Leiterplatte r auf Linie $l$
$TimeLimit_l$      Produktionszeitschranke auf Linie $l$

**Binär-Variablen**

$Assign_{r,l}$      Zuordnung Leiterplatte r zu Linie $l$
$Setup_{c,l}$      Verwendung eines Bauelements c auf einer Linie $l$

**IP Formulierung**

$$\text{minimize} \sum_{c \in C} \sum_{l \in L} Setup_{c,l}$$

s.t. :

$$\sum_{l \in L} Assign_{r,l} = 1 \qquad\qquad r \in R$$

$$Assign_{r,l} = 0 \qquad\qquad l \in L, r \in R / R_l$$

$$\sum_{r \in R_c} Assign_{r,l} \leq Setup_{c,l} |R_c| \qquad\qquad c \in C, l \in L$$

$$\sum_{r \in R} Assign_{r,l} Time_{r,l} \leq TimeLimit_l \qquad\qquad l \in L$$

$$Setup_{c,l} \in \{0,1\} \qquad\qquad c \in C, l \in L$$

$$Assign_{r,l} \in \{0,1\} \qquad r \in R, l \in L$$

Zur Verbesserung der Zuordnung von komplexen Leiterplatten 120 über die Bestückungslinien 110 können dem Solver weitere Bedingungen zur Verfügung gestellt werden.

Eine erste Forderung kann darin bestehen, einer Bestückungslinie l nur eine vorbestimmte Anzahl $MaxCountBig_l$ an Leiterplatten bzw. Baugruppen 120 von paarweise stark unterschiedlichen Leiterplatten 120 mit hoher Bauteilevarianz zuzuordnen. Dabei wird MaxCountBig$_l$ gewöhnlich sehr niedrig gewählt, in der Regel 1 oder 2.

$$\forall l \in L : \sum_{r \in R_{Big}} Assign_{r,l} \leq MaxCountBig_l$$

mit:

| | |
|---|---|
| $l$ | Bestückungslinie 110 |
| $MaxCountBig$ | erste vorbestimmte Anzahl |
| $R_{Big}$ | Menge 200 von paarweise stark unterschiedlichen Leiterplatten $l$. |

Ferner kann gefordert werden, dass jeder Linie $l$ eine minimale Anzahl $MinCountBig_l$ an Leiterplatten aus der Menge $R_{Big}$ zugeordnet werden soll. Dabei wird $MinCountBig_l$ üblicherweise sehr niedrig gewählt, in der Regel nur 1.

$$\forall l \in L : \sum_{r \in R_{Big}} Assign_{r,l} \geq MinCountBig_l$$

mit:

| | |
|---|---|
| $MinCountBig$ | zweite vorbestimmte Anzahl. |

Darüber hinaus kann noch gefordert werden, dass einer Bestückungslinie $l$ eine Leiterplatte $r$ nicht zusammen mit einer Leiterplatte $r'$ aus einer Menge $RF_{r,l}$ zugeordnet werden soll.

$$\forall l \in L : |RF_{r,l}|Assign_{r,l} + \sum_{r' \in RF_{r',l}} Assign_{r',l} \leq |RF_{r,l}|$$

Durch Anwendung wenigstens eines dieser Kriterien kann eine verbesserte Verteilung der komplexen Leiterplatten 120 über die Bestückungslinen 110 erzielt werden, so dass Umrüstungen von Bestückungslinien 110 verringert werden können. Außerdem können Produktionszeiten von Leiterplatten 120 im Bestückungssystem 100 verbessert werden. Ferner können die Zuordnungen mit dem beschriebenen Ansatz mittels eines IP-Solvers rascher als bislang bekannt bestimmbar sein.

Obwohl die Erfindung im Detail durch das bevorzugte Ausführungsbeispiel näher illustriert und beschrieben wurde, so ist die Erfindung nicht durch die offenbarten Beispiele eingeschränkt und andere Variationen können vom Fachmann hieraus abgeleitet werden, ohne den Schutzumfang der Erfindung zu verlassen.

**Patentansprüche**

1. Verfahren (300) zur Bestückung von Leiterplatten (120) mittels Bestückungslinien (110) eines Bestückungssystems (100) zur Bestückung der Leiterplatten (205, 215) mit elektronischen Bauteilen (155), wobei das Verfahren folgende Schritte umfasst:

   - Erfassen (305) von Anforderungen zur Bestückung mehrerer Leiterplatten (110, 205, 215) mit jeweils zu bestückenden Bauteilen (155),

- wobei eine Anforderung eine Leiterplatte (120) und die auf ihr zu bestückenden Bauteile (155) definiert;

- Bestimmen (315) einer Menge (200) von Leiterplatten (110), deren Bauteilevarianzen ein vorbestimmtes Maß übersteigen,

- wobei eine Bauteilevarianz einer Leiterplatte (120) jeweils die Anzahl unterschiedlicher auf einer Leiterplatte (110, 205, 215) zu bestückender Bauteile (155) repräsentiert;

- Bestimmen von Leiterplatten (110, 205, 215) aus der Menge (200), die paarweise stark unterschiedliche Mengen (225, 230) von Bauteilen (155) erfordern;

- Zuordnen (345) der Leiterplatten (110, 205, 215) aus der Menge (200) mittels ganzzahliger Linearer Programmierung an die Bestückungslinien (110) derart, dass die bestimmten Leiterplatten (110, 205, 215) möglichst unterschiedlichen Bestückungslinien (110) zugeordnet sind und die Summe von Bauteilvarianzen der Bestückungslinien (110) möglichst minimiert ist,

- wobei die Bauteilevarianz einer Bestückungslinie (110) die Anzahl unterschiedlicher auf der Bestückungslinie (110) verwendeter Bauteiltypen repräsentiert;

- wobei das ganzzahlige Lineare Programm ein Ermitteln (405) einer Startzuordnung von Leiterplatten (110, 205, 215) auf Bestückungslinien (110) als aktuelle Zuordnung und ein Zuordnen (415) von Leiterplatten (110, 205, 215) der Menge (200) auf die Bestückungslinien (110), basierend auf der aktuellen Zuordnung mittels eines Optimierungsprogramms mittels ganzzahliger Linearer Programmierung umfasst, und

- Bestücken der Leiterplatten (120) auf den jeweils zugeordneten Bestückungslinien (110).

2.  Verfahren (300) nach Anspruch 1, wobei einer Bestückungslinie (110) nicht mehr als eine vorbestimmte Anzahl, beispielsweise eine oder zwei, Leiterplatten (110, 205, 215) aus der Menge (200) zugeordnet wird.

3.  Verfahren (300) nach Anspruch 1 oder 2, wobei einer Bestückungslinie (110) wenigstens eine vorbestimmte Anzahl Leiterplatten (110, 205, 215) aus der Menge (200) zugeordnet wird.

4.  Verfahren (300) nach einem der vorangehenden Ansprüche, wobei eine Zuordnung zweier Leiterplatten (110, 205, 215) an eine Bestückungslinie (110) verhindert wird, falls die Bauteilevarianz der symmetrischen Differenz der auf den beiden Leiterplatten (110, 205, 215) zu bestückenden Bauteile (155) eine vorbestimmte erste Schranke übersteigt.

5.  Verfahren (300) nach Anspruch 4, wobei die Zuordnung nur verhindert wird, falls auch die Bauteilevarianzen beider Leiterplatten (110, 205, 215) jeweils eine vorbestimmte zweite Schranke übersteigen.

6.  Verfahren (300) nach Anspruch 4 oder 5, wobei die Zuordnung nur verhindert wird, falls auch die Bauteilevarianz der Vereinigungsmenge der auf den beiden Leiterplatten (110, 205, 215) zu bestückenden Bauteile (155) eine vorbestimmte dritte Schranke übersteigt.

7.  Verfahren (300, 400) nach einem der vorangehenden Ansprüche, wobei die Schritte des ganzzahligen Linearen Programms iterativ durchgeführt werden, bis die bestimmte Zuordnung eine vorbestimmte Qualität bezüglich der Minimierung der Bauelementevarianz aller Bestückungslinien (110) erreicht hat oder eine vorbestimmte Verarbeitungszeit abgelaufen ist (425) .

8.  Computerprogrammprodukt mit Programmcodemitteln zur Durchführung des Verfahrens (300, 400) nach einem der vorangehenden Ansprüche, wenn es auf einer Ausführungseinrichtung (115) abläuft.

9.  Steuereinrichtung (115) zur Durchführung eines Verfahrens (300) nach einem der Ansprüche 1 bis 7.


**Claims**

1.  Method (300) for fitting printed circuit boards (120) by means of fitting lines (110) of a fitting system (100) for fitting the printed circuit boards (205, 215) with electronic components (155), the method comprising the following steps:

    - detecting (305) requirements for fitting a plurality of printed circuit boards (110, 205, 215) with components (155) to be respectively fitted,
    - a requirement defining a printed circuit board (120) and the components (155) to be fitted thereon;
    - determining (315) a set (200) of printed circuit boards (110), the component variances of which exceed a predetermined amount,
- a component variance of a printed circuit board (120) respectively representing the number of different components (155) to be fitted on a printed circuit board (110, 205, 215);
- determining printed circuit boards (110, 205, 215) from the set (200) which in pairs require highly different sets (225, 230) of components (155),
- allocating (345) the printed circuit boards (110, 205, 215) from the set (200) to the fitting lines (110) by means of integer linear programming in such a manner that the determined printed circuit boards (110, 205, 215) are allocated to fitting lines (110) which are as different as possible and the sum of component variances of the fitting lines (110) is minimized as far as possible,
- the component variance of a fitting line (110) representing the number of different component types used on the fitting line (110);
- the integer linear program comprising a determination (405) of a starting allocation of printed circuit boards (110, 205, 215) to fitting lines (110) as the current allocation and an allocation (415) of printed circuit boards (110, 205, 215) in the set (200) to the fitting lines (110) based on the current allocation by means of an optimization program by means of integer linear programming, and
- fitting the printed circuit boards (120) with components on the respectively allocated fitting lines (110).

2. Method (300) according to Claim 1, no more than a predetermined number of, for example one or two, printed circuit boards (110, 205, 215) from the set (200) being allocated to a fitting line (110).

3. Method (300) according to Claim 1 or 2, at least a predetermined number of printed circuit boards (110, 205, 215) from the set (200) being allocated to a fitting line (110).

4. Method (300) according to one of the preceding claims, allocation of two printed circuit boards (110, 205, 215) to a fitting line (110) being prevented if the component variance of the symmetrical difference between the components (155) to be fitted on both printed circuit boards (110, 205, 215) exceeds a predetermined first limit.

5. Method (300) according to Claim 4, the allocation being prevented only if the component variances of both printed circuit boards (110, 205, 215) also each exceed a predetermined second limit.

6. Method (300) according to Claim 4 or 5, the allocation being prevented only if the component variance of the union of the components (155) to be fitted on both printed circuit boards (110, 205, 215) also exceeds a predetermined third limit.

7. Method (300, 400) according to one of the preceding claims, the steps of the integer linear program being carried out iteratively until the particular allocation has reached a predetermined quality with respect to minimizing the component variance of all fitting lines (110) or a predetermined processing time has expired (425).

8. Computer program product with program code means for carrying out the method (300, 400) according to one of the preceding claims if the computer program product runs on an execution device (115).

9. Control device (115) for carrying out a method (300) according to one of Claims 1 to 7.

**Revendications**

1. Procédé (300) d'équipement de cartes de circuits imprimés (120) au moyen de lignes de montage (110) d'un système de montage (100) destiné à équiper les cartes de circuits imprimés (205, 215) de composants électroniques (155), le procédé comportant les étapes suivantes :

- saisie (305) d'exigences relatives à l'équipement de plusieurs cartes de circuits imprimés (110, 205, 215) avec des composants (155) à monter respectivement,
- une exigence définissant une carte de circuit imprimé (120) et les composants (155) à monter dessus ;
- détermination (315) d'une quantité (200) de cartes de circuits imprimés (110) dont les variances des composants dépassent une mesure prédéterminée,
- une variance de composants d'une carte de circuit imprimé (120) représentant respectivement le nombre de composants différents (155) à monter sur une carte de circuit imprimé (110, 205, 215) ;
- détermination, dans la quantité (200), de cartes de circuits imprimés (110, 205, 215) qui, par paire, nécessitent des ensembles (225, 230) fortement différents de composants (155) ;
- affectation (345) des cartes de circuits imprimés (110, 205, 215) de la quantité (200) au moyen d'une programmation linéaire en nombres entiers aux lignes de montage (110) de telle sorte que les cartes de circuits imprimés déterminées (110, 205, 215) sont affectées à des lignes de montage (110) les plus différentes possible et que la somme de variances de composants des lignes de montage (110) est minimisée le plus possible,
- la variance de composants d'une ligne de montage (110) représentant le nombre de types de composants différents utilisés sur la ligne de montage (110) ;
- le programme linéaire en nombres entiers comprenant une détermination (405) d'une affectation de départ de cartes de circuits imprimés (110, 205, 215) sur des lignes de montage (110) en tant qu'affectation actuelle et une affectation (415) de cartes de circuits imprimés (110, 205, 215) de la quantité (200) aux lignes de montage (110) sur la base de l'affectation actuelle au moyen d'un programme d'optimisation au moyen d'une programmation linéaire en nombres entiers et
- montage des cartes de circuits imprimés (120) sur les lignes de montage (110) respectivement associées.

2. Procédé (300) selon la revendication 1, à une ligne de montage (110) n'étant pas affecté plus qu'un nombre prédéterminé de cartes de circuits imprimés (110, 205, 215) de la quantité (200), par exemple, une ou deux.

3. Procédé (300) selon la revendication 1 ou 2, à une ligne de montage (110) étant affecté au moins un nombre prédéterminé de cartes de circuits imprimés (110, 205, 215) de la quantité (200) .

4. Procédé (300) selon l'une des revendications précédentes, une affectation de deux cartes de circuits imprimés (110, 205, 215) à une ligne de montage (110) étant empêchée si la variance des composants de la différence symétrique des composants (155) à monter sur les deux cartes de circuits imprimés (110, 205, 215) dépasse une première limite prédéterminée.

5. Procédé (300) selon la revendication 4, l'affectation étant seulement empêchée si les variances des composants de deux cartes de circuits imprimés (110, 205, 215) dépassent aussi respectivement une deuxième limite prédéterminée.

6. Procédé (300) selon la revendication 4 ou 5, l'affectation étant seulement empêchée si la variance des composants de la quantité combinée des composants (155) à monter sur les deux cartes de circuits imprimés (110, 205, 215) dépasse aussi une troisième limite prédéterminée.

7. Procédé (300, 400) selon l'une des revendications précédentes, les étapes du programme linéaire en nombres entiers étant effectuées itérativement jusqu'à ce que l'affectation déterminée ait atteint une qualité prédéterminée au regard de la minimisation de la variance des composants de toutes les lignes de montage (110) ou jusqu'à ce qu'un temps de traitement prédéterminé se soit écoulé (425).

8. Produit de programme informatique avec des moyens de code de programme pour exécuter le procédé (300, 400) selon l'une des revendications précédentes s'il tourne sur un dispositif d'exécution (115).

9. Dispositif de commande (115) pour exécuter un procédé (300) selon l'une des revendications 1 à 7.

# FIG 1

FIG 2

FIG 3

FIG 4

**IN DER BESCHREIBUNG AUFGEFÜHRTE DOKUMENTE**

*Diese Liste der vom Anmelder aufgeführten Dokumente wurde ausschließlich zur Information des Lesers aufgenommen und ist nicht Bestandteil des europäischen Patentdokumentes. Sie wurde mit größter Sorgfalt zusammengestellt; das EPA übernimmt jedoch keinerlei Haftung für etwaige Fehler oder Auslassungen.*

**In der Beschreibung aufgeführte Patentdokumente**

- DE 102009013353 B3
- EP 0478360 A1
- EP 0478361 A1

**In der Beschreibung aufgeführte Nicht-Patentliteratur**

- **HANS-OTTO GÜNTHER et al.** Workload planning in small lot printed circuit board assembly. *OR Spectrum,* 01. Juni 1997, vol. 19 (2), 147-157